# EUROPEAN PATENT SPECIFICATION

(11) **EP 1 855 381 B1**
(45) Date of publication and mention of the grant of the patent: **05.01.2011**
(21) Application number: 06009555.1
(22) Date of filing: 09.05.2006
(51) Int. Cl.: H02M 1/38, H03K 17/691, H03K 17/284

(54) **Drive unit for a half bridge converter**
Treibereinheit für einen Halbbrückenumrichter
Unité de commande pour un convertisseur à demi-pont

(43) Date of publication of application: 14.11.2007
(73) Proprietor: Vestel Elektronik Sanayi ve Ticaret A.S., 45030 Manisa (TR)
(72) Inventor: Dag, Bulent, 45030 Manisa (TR)
(74) Representative: HOFFMANN EITLE

(56) References cited:
- EP-A- 1 379 109
- HASSIG H R ET AL: "ZUVERLASSIGER BETRIEB VON MOSFETS IN BRUCKENSCHALTUNGEN" ELEKTRONIK, WEKA FACHZEITSCHRIFTENVERLAG, POING, DE, vol. 38, no. 10, 12 May 1989 (1989-05-12), pages 55-56,58, XP000071433 ISSN: 0013-5658
- KWON J-M ET AL: "High-performance plasma-display-panel sustain power supply" IEE PROCEEDINGS: ELECTRIC POWER APPLICATIONS, INSTITUTION OF ELECTRICAL ENGINEERS, GB, vol. 152, no. 6, 4 November 2005 (2005-11-04), pages 1381-1388, XP006025431 ISSN: 1350-2352

## Description

### FIELD OF THE INVENTION

The invention generally relates to power electronics, switching power supplies and in particular to a drive unit for driving a half bridge converter, for example a half bridge in a switching power supply. The invention also relates to such a half bridge converter for converting a DC input voltage to a DC output voltage. In particular, the present invention can be specifically adopted to half-bridge flyback DC to DC converter topology. However, it should be noted that the inventive drive unit can be applied, in principle, to any type of half bridge converter.

Thus, the present invention aims at a novel drive unit for half bridge switching structures in which two serially connected MOSFET transistors of a switching stage are switched alternately with complementary first and second switching signals, wherein the novel drive unit is extremely simple in its structure, is cost and size efficient and allows a half-bridge flyback circuit driven by it to be power efficient whilst at the same time having low switching losses, as will be discussed with more details hereinafter.

### BACKGROUND OF THE INVENTION

Typically, half-bridge switching structures are used in circuits to convert a DC voltage to a square wave. The DC voltage amplitude is modified by a transformer and the resulting square wave is filtered to AC or rectified back to a predetermined DC level. Such techniques can be used for devices requiring several DC voltage levels, such as a Plasma Display Panel, a TFT-LCD TV, Laptop power supplies or generally devices requiring DC to AC conversion such as LCD backlight inverters.

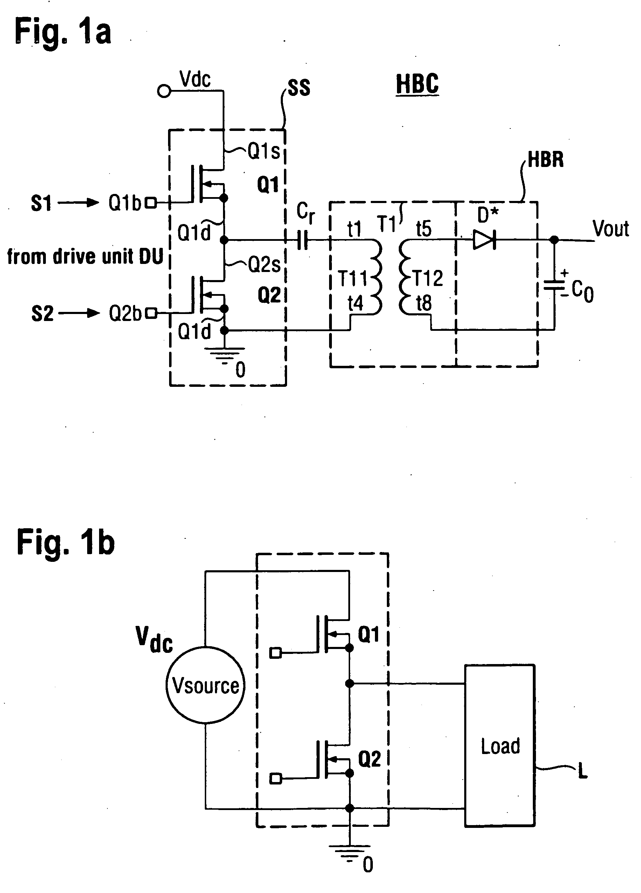

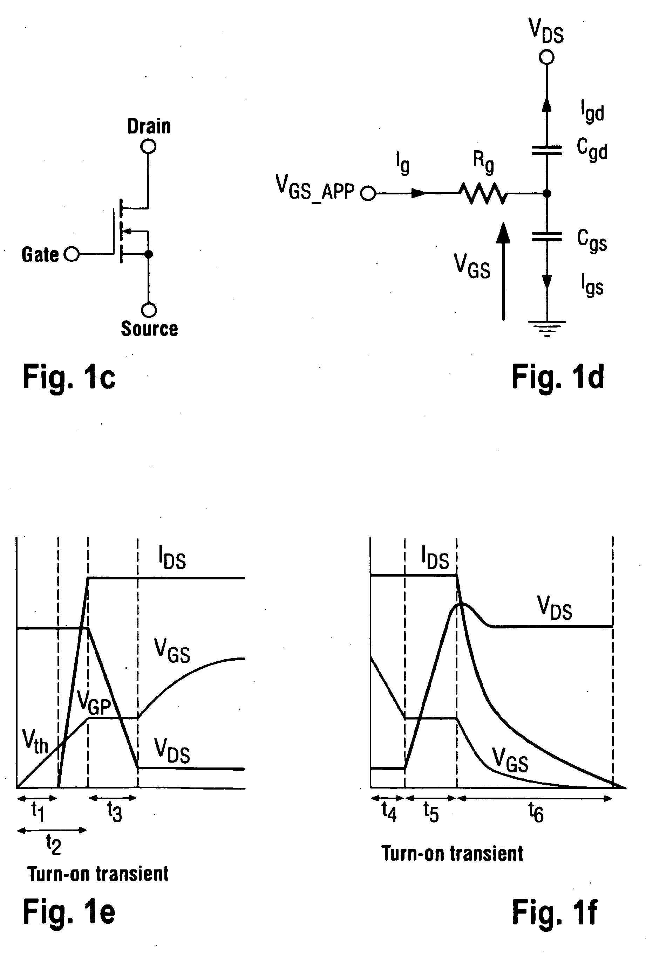

In recent years, a switching DC-DC converter topology called Half Bridge Flyback Converter has been widely used especially in consumer electronics for medium power applications such as Plasma Display Panel Power supplies because of its high efficiency and simple structure reducing the cost. Fig. 1 shows a principle block diagram of such a conventional half bridge converter HBC.

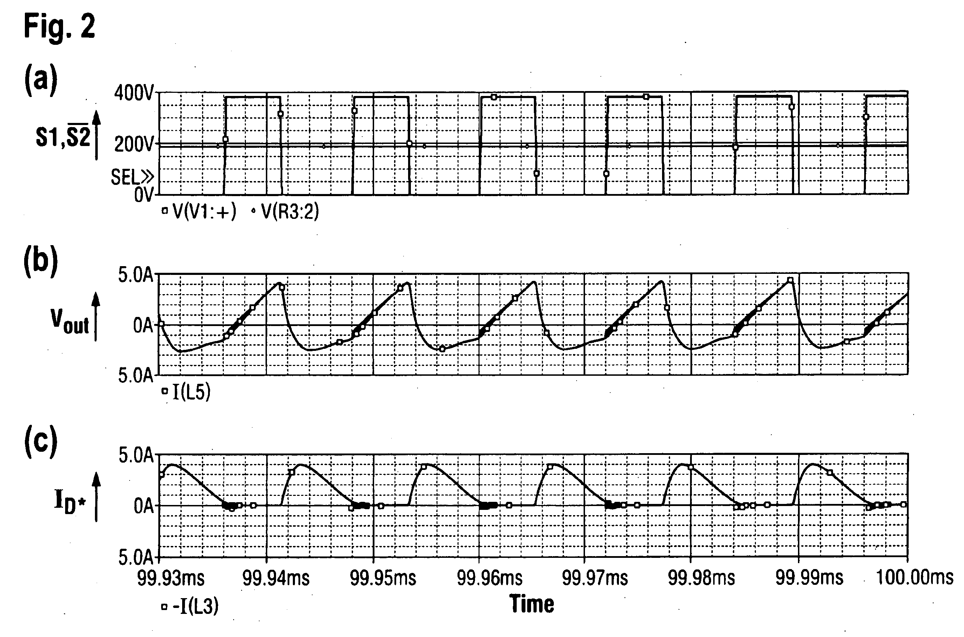

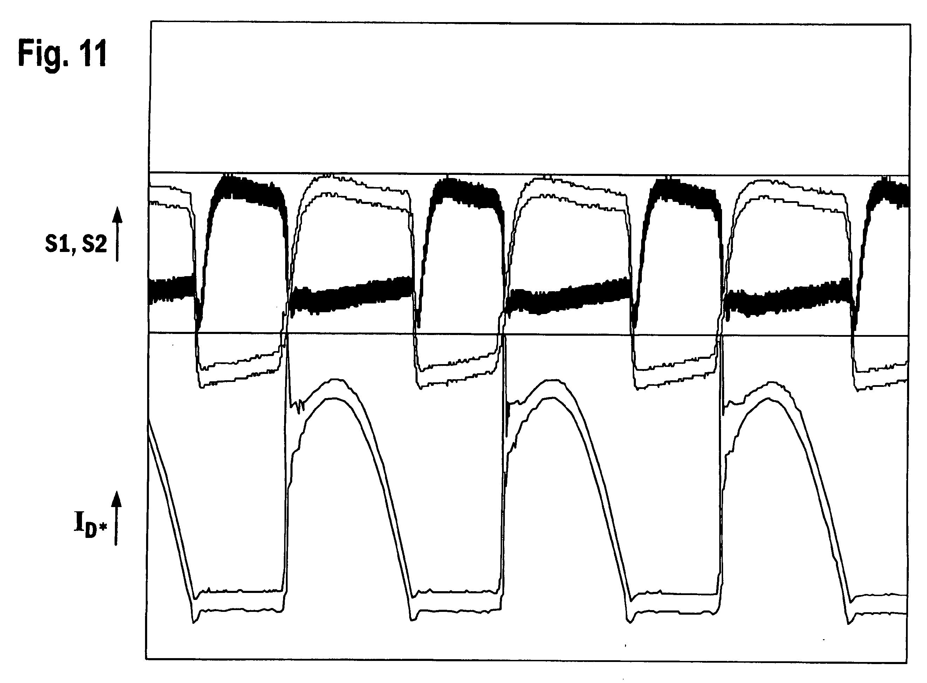

In Fig. 1, the conventional half bridge converter HBC commonly comprises a switching stage SS comprising two serially connected switching elements Q1, Q2 such as MOSFET transistors Q1, Q2 and an output transformer T1 having a primary winding T11 connected to said switching stage SS and a secondary winding T12. The source Q1s of said first switching transistor Q1 is serially connected to the drain Q2d of said second switching element. A half bridge rectifier HBR, for example formed by a diode D* and a capacitor Co, is connected to said output transformer secondary winding T12 and outputs a DC output voltage Vout. When complementary switching signals S1, S2 (see for example Fig. 11) are applied to the gate (control) terminals Q1b, Q2b of said switching transistors from a drive unit DU (not shown in Fig. 1), a half wave DC rectified output voltage Vout will be output from the output of the rectifier HBR (Fig.2a shows the signals at the outputs of MOSFETS, here Q1d and Q2s when the switching signals are applied). Generally, the switching signals S1, S2 are PWM (Pulse Width Modulated) switching signals S1, S2 the pulse width of which corresponding to a predetermined input DC voltage. The pulse width also depends on the output DC voltage because of a feedback, and on the frequency.

As shown in Fig. 1, the two switching elements Q1, Q2 are connected in series forming a Half Bridge structure and the primary winding T11 with its terminals t1, t4 is connected in parallel over the second switching element Q2, namely over its source Q2s and drain Q2d terminals through a DC blocking and resonating capacitor Cr. The secondary side of the output transformer T1 comprises the flyback rectifying diode D* and said DC boost capacitor C0.

Fig. 2a shows the input and output voltages, Fig. 2b shows the input current and Fig. 2c shows the output diode current waveforms respectively at steady-state operating condition of the converter HBC shown in Fig. 1. As seen from the input voltage waveform in Fig. 2a, the switching on-off scheme of the switching signals S1, S2 is in accordance with a conventional flyback converter concept for the desired output voltage level and is also dependent on the transformer winding turn ratio. A detailed operation description of such a conventional Half Bridge Flyback Converter can be found in J.-M. Kwon, W.-Y. Choi, B.-H. Kwon: "High-Performance Plasma-Display-Panel 'Sustain' Power Supply", IEE Proc.-Electr. Power Appl., Vol.152, No.6, November 2005.

When the input current waveform (b) in Fig. 2b is analysed, it can be seen that the switches Q1, Q2 perform a so called Zero Voltage Switching (ZVS) for Q1 at the end of the energy transfer cycle in which Q2 is conducting and for Q2 at the end of the energy storage cycle in which Q1 is conducting. Furthermore during the energy transfer cycle, resonant output current (due to the resonance between the capacitor Cr and leakage inductor of the output transformer T1) passing through the output diode D* of the rectifier HBR can be clamped at zero (see Fig. 2c) such that switching losses are further reduced.

### PUBLISHED PATENT PRIOR ART

Whilst Fig. 1 and Fig. 2 show the principle block diagram and the operation of a conventional Half Bridge Flyback Converter HBC, several published prior art patent documents disclose drive units for driving such a Half Bridge Flyback Converter HBC.

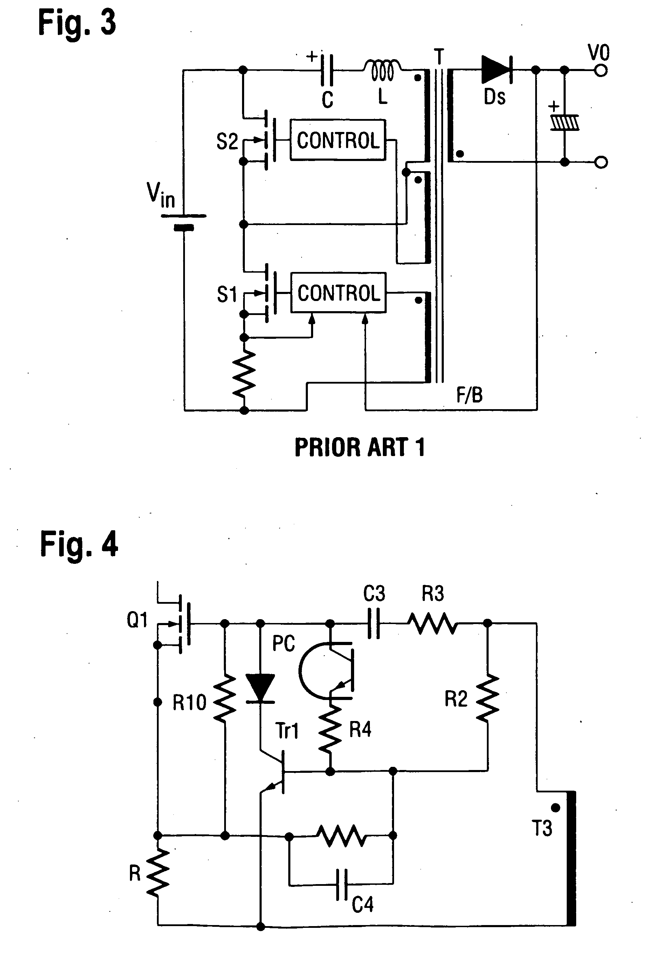

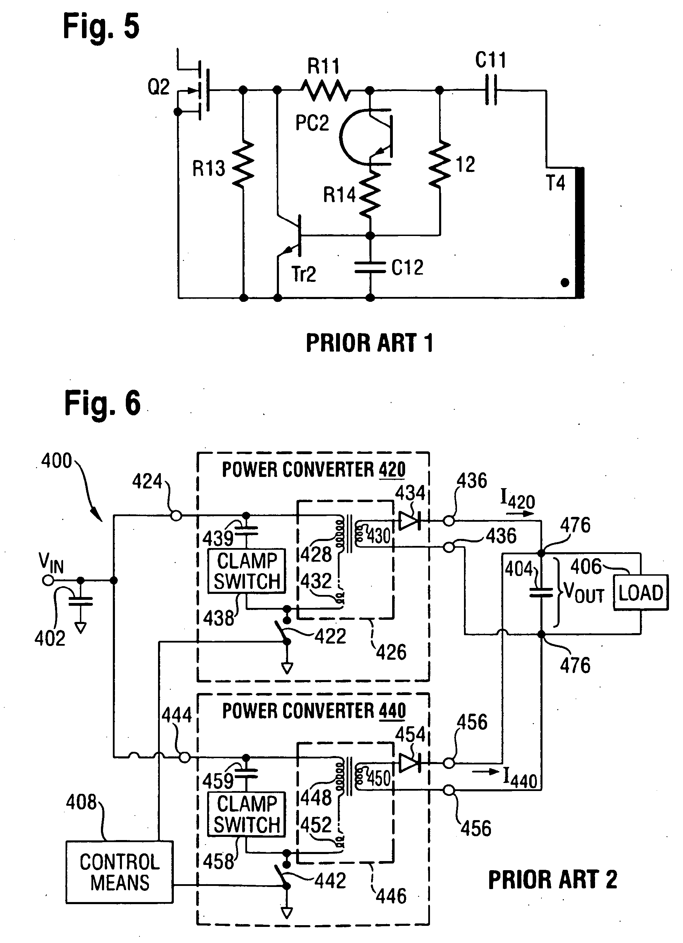

For example, US Patent No. 6.639.811 B2 discloses a Half bridge Flyback Converter unit (hereinafter "prior art 1") and its self oscillating switching drive concept in a configuration where the load block is connected in parallel to switching element Q1 instead of switching element Q2 thus interchanging the functions of the switch elements but in principle having the same main operating principle. In this drive unit both switching elements in the half bridge structure are driven by means of two additional auxiliary winding on the transformer T1 and two separate electronics blocks providing fixed on-time for both the energy storage cycle (when Q1 is on) and the energy transfer cycle (when Q2 is on) without using any controller integrated circuit (IC). The principle block diagrams of the disclosed self oscillating power supply unit of "prior art 1" are shown in Fig. 3, Fig. 4 and Fig. 5.

Switching power supply units similar to the one in "prior art 1" and including two switching elements in the primary side and a corresponding drive unit are disclosed in US Patent No. 5.796.595, Japanese Unexamined Patent Application No. 4-87560 and Japanese Unexamined Utility Model Publication No. 6-36392. However, the disclosed drive concept in these publications is not self oscillating but uses a controller IC of two complementary output drives with a time delay produced within itself. The drive unit disclosed in US Patent No. 5.796.595 is shown in Fig. 6 (hereinafter called "prior art 2").

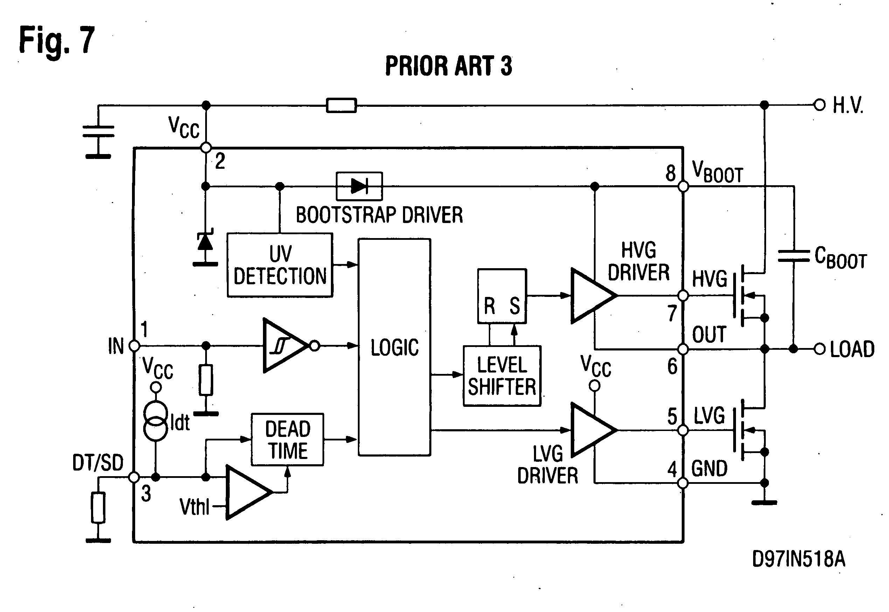

Commercially available Half bridge drive units in the form of integrated circuits (Ics) are known under the model numbers L6384 and IR2184 (hereinafter called "prior art 3"). These drive ICs have one input pin and two complementary outputs outputting the complementary switching signals. This type of drive unit IC has its own time delay function between the output drive signals together with isolated ground high side switch drive circuit in one integrated circuit and Fig. 7 shows a principle block diagram of the drive unit IC model number L6384.

Hässig and Zoller (in "Elektronik", No.10 of 12 .Mai 1989 ,p.55-63) describe drive units for bridge converters with MOSFET transistors.

The drive signals are coupled to the transistors via an insulation transformer.

In fig.2 are some configurations discussed to realise a dead time circuit between transformer and switched transistor.

### DISADVANTAGES OF THE PRIOR ART

Whilst in principle the prior art drive units shown in Figs. 1a, Fig. 2 and Figs 3-7 work well, there are a number of disadvantages in the self oscillating Half bridge drive unit disclosed in US Patent No. 6.639.811 B2, the switching power supply unit using switching controllers disclosed in US Patent No. 5.796.595, and the one chip half bridge drivers. These disadvantages, as realized by the inventors, are described hereinafter.

In this self oscillating Half Bridge Flyback Power supply unit of US Patent No. 6.639.811 B2 no controller IC is needed such that the overall cost is reduced when compared with drive units using controller ICs. However, the amount of the active and passive components used in both switching drive circuits and those in the starting circuit increase the PCB size enormously.

Furthermore, in the on-time control circuit driving the switching element S2 in Fig. 3, the switching element S2 is turned off before the energy transfer to the secondary side is fully completed such that there is generated a turn-on voltage at the drive (secondary) winding of the switching element S1. This process requires turn-off of the output diode Ds at a current larger than a zero value which increases the output diode switching losses.

On the other hand, the type of switching power supply unit disclosed in US Patent No. 5.796.595 does not have a self oscillating unit but uses a controller integrated circuit (IC) with two drive outputs with or without a pulse transformer or a single output PWM driver with a Half bridge high side driver of two outputs providing a required time delay between the switching and the drive signal for the high side switching element which is at a different ground level. In this case, although the interrupt of energy transfer to the secondary side is not required, very high prices of this kind of ICs increases the cost enormously.

Finally, the one chip solutions such as L6384 and IR2184 for a half bridge drive unit as disclosed in prior art 3 have a compact solution, whereas their extremely high prices makes them unattractive.

### SUMMARY OF THE INVENTION

In view of the above disadvantages, the object of the present invention is to provide a drive unit for a half bridge converter and a half bridge converter using such a drive unit such that the novel drive unit is extremely simple in its structure, is cost and size efficient and allows a half-bridge flyback circuit driven by it to be power efficient whilst at the same time having low switching losses.

This object is solved by a drive unit for a half bridge converter according to independent claim 1.

Said drive unit is **characterized in that** each time delay circuit respectively comprises a transistor, a resistor, a capacitor and a diode. Such a diode preferably also contributes to the delay operation and is not used only for protection purposes.

Preferably, said drive unit is **characterized in that** said time delay circuits introduce a respective time delay such that one switching element is switched off completely before the other one switching element switches on.

Preferably, said drive unit is **characterized in that** said each time delay circuit is respectively connected serially at the output terminal of the respective secondary winding.

Preferably, said drive unit is **characterized in that** a first input terminal of said primary winding is connected to ground.

Preferably, said drive unit is **characterized in that** a coupling capacitor is connected to a second input terminal of said primary winding.

Preferably, said drive unit is **characterized in that** a first and second over voltage protection circuit is respectively provided at the output of said first and second time delay circuit for respectively protecting said first and second switching element from over voltages.

Preferably, said drive unit is **characterized in that** said each over voltage protection circuit comprises a number of Zener diodes.

Preferably, said drive unit is **characterized in that** said control pulse signal is a pulse width modulated control pulse signal, said first and second switching pulse signals and said time delayed first and second switching pulse signals are PWM switching signals and said controller is a PWM controller.

Preferably, said drive unit is **characterized in that** said aid PWM controller is a single output voltage mode PWM controller. with a drive unit as defined in claims 1 to 8

Furthermore, the above object is solved by a half bridge converter with a drive unit as defined in claims 1 to 8 for converting a DC input voltage to a DC output voltage, comprising a switching stage comprising two serially connected switching elements, an output transformer having a primary winding connected to said switching stage and a secondary winding, a half bridge rectifier connected to said output transformer, said half bridge rectifier outputting said DC output voltage, wherein said first and second time delayed switching pulse signals are fed to a respective control terminal of said first and second switching element of said switching stage of said half bridge converter.

Preferably, said half bridge converter is **characterized in that** said switching elements are constituted by MOSFET transistors.

Preferably, said half bridge converter is **characterized in that** said output transformer is connected to said switching stage through a resonant coupling capacitor.

Preferably, said half bridge converter is **characterized in that** the terminals of said primary winding of said output transformer are respectively connected to a drain and a source of one of said serially connected MOSFETs of said switching stage.

Preferably, said half bridge converter is **characterized in that** said one terminal of said primary winding of said output transformer is connected to the source of one MOSFET of said serially connected MOSFETs, and the second terminal of said primary winding of said output transformer is connected to the drain of said one MOSFET.

Preferably, said half bridge converter is **characterized in that** said half bridge converter (HBC) is a half bridge flyback converter.

A main advantage achieved by using the inventive drive unit and the half bridge converter using such a drive unit is that the zero current switching of an output diode can be provided in a simple and cost efficient manner in a half bridge flyback converter unit, and a conventional single output PWM controller IC with self time shifting pulse transformer can be used in the half bridge drive unit which also reduces the cost considerably.

A further advantage is that by using two time delay circuits respectively at the output secondary windings of an output transformer and by providing a self time delay unit over it, both the drive of the high side switch of a half bridge structure and a time delay between the two switching elements can be provided in a very cheap manner without the need to use a half bridge driver IC including a High side drive and time delay properties within itself. Using the time delay circuits a time shift between the two complementary switching operations is guaranteed which reduces the switching losses as will be explained with more details below.

Further advantageous embodiments and improvements of the invention are listed in the dependent claims. In particular, the invention may also comprise combinations of features and functional steps which have been separately listed in the claims, the specification and shown in the drawings.

Hereinafter, the invention will be described with reference to its advantageous embodiments and by reference to the attached drawings.

### BRIEF DESCRIPTION OF THE DRAWINGS

- Fig. 1a: shows a circuit diagram of a conventional Half bridge Flyback converter HBC;
- Fig. 1b: shows a principle circuit diagram of the switching stage SS shown in Fig. 1a;
- Fig. 1c: shows a principle schematic of a MOSFET switching element used in the switching stage SS shown in Fig. 1b;
- Fig. 1d: shows an equivalent circuit diagram of the MOSFET switching element shown in Fig. 1c during switching; and
- Fig. 1e & 1f: respectively show the turn-on transient characteristics and the turn-off transient characteristics of the MOSFET switching element shown with the equivalent schematic in Fig. 1b;
- Fig. 2: shows steady-state input and output voltage (a), input current (b) and output diode current (c) waveforms of the Half bridge Flyback converter HBC shown in Fig. 1;
- Fig. 3: shows schematics of a converter unit in accordance with a disclosed Prior Art 1;
- Fig. 4: shows schematics of fix on time circuit driving switching element S1 in Fig. 3;
- Fig. 5: shows schematics of fix on time circuit driving switch S2 in Fig. 3;
- Fig. 6: shows schematics of the power supply unit disclosed in a disclosed Prior Art 2;
- Fig. 7: shows a block diagram of a disclosed Prior Art 3;
- Fig. 8a: shows a block diagram of a drive unit DU in accordance with the principle of the invention;
- Fig. 8b: shows an embodiment of the drive unit DU shown in Fig. 8a;
- Fig. 9: shows a first embodiment of a half bridge converter HBC in accordance with the present invention using a drive unit DU as shown in Fig. 8a;
- Fig. 10: shows a second embodiment of a half bridge converter HBC in accordance with the present invention using a drive unit DU as shown in Fig. 8a; and
- Fig. 11: shows the switching signals S1, S2 and the output current in the embodiment in Fig. 8a, 8b.

### PRINCIPLE OF THE INVENTION

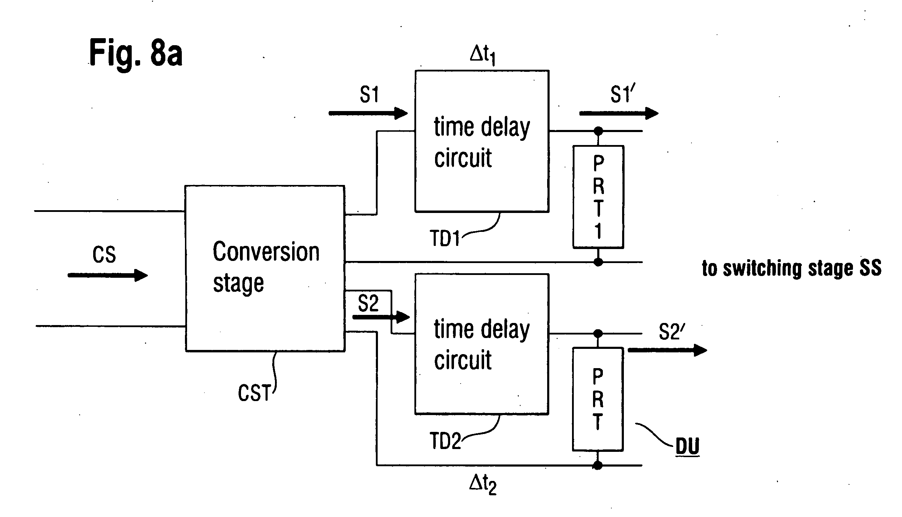

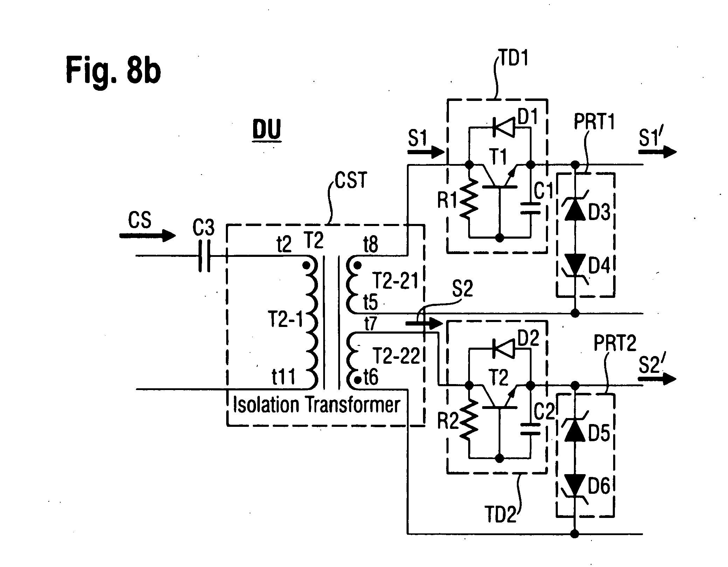

Hereinafter, the invention will be described with reference to its advantageous embodiments with reference to the drawings. However, at first the general principle of the invention will be explained in its broadest aspects with reference to Fig. 8a and with reference to the timing aspects as illustrated in Figs. 1b-1f. Thus, Fig. 8a shows a principle block diagram of a drive unit DU in accordance with the invention and Figs. 1b-1f serve explanation of the timing related aspects in the drive unit DU of Fig. 8a. Fig. 11 shows the switching signals S1, S2 and the output current in the embodiment in Fig. 8a, 8b.

In Fig. 8a, a block diagram of a drive unit DU in accordance with the principle of the invention is shown and Fig. 8b shows a special embodiment of the drive unit DU in Fig. 8a.

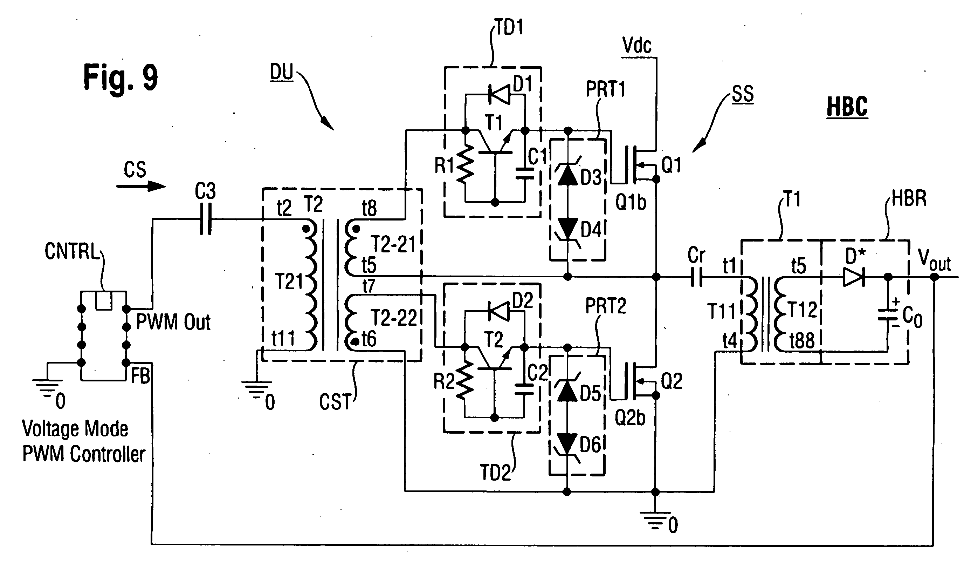

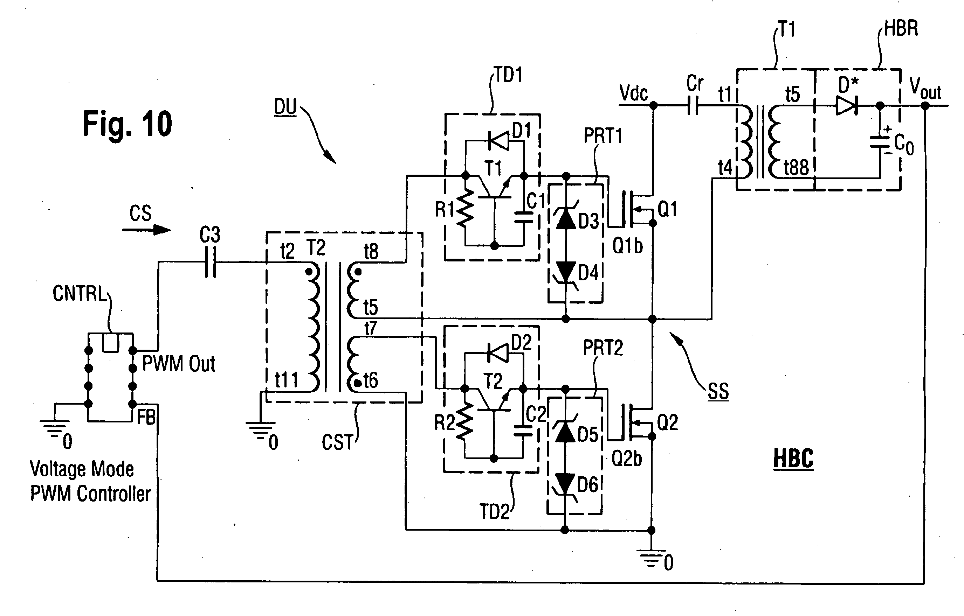

The drive unit DU comprises a conversion stage CST, preferably a transformer T2 having a primary winding T2-1 and two secondary windings T2-21, T2-22, said primary winding T2-1 receiving a control pulse signal CS from a controller (not shown in Fig. 8a and Fig. 8b but shown with reference numeral CNTRL in Fig. 9 and Fig. 10) and said two secondary windings T2-21, T2-22 outputting a first and second switching pulse signal S1, S2. Said first and second switching pulse signals S1, S2 are complementary to each other like the signals S1, S2 discussed above in connection with Fig. 1a and Fig 2.

In Fig. 8a there is also shown a first and a second time delay circuit TD1, TD2 which respectively receives said first and second complementary switching signal S1, S2. Each time delay circuit introduces a respective time delay Δt1, Δt2 in said first and second switching signal S1, S2. The first and second time delayed switching pulse signals S1', S2' are then fed to a first and second switching element Q1, Q2, such as a respective MOSFET shown in Fig. 1s, of the switching stage SS of said half bridge converter HBC.

Furthermore, although not relevant for the actual switching and control properties of the drive unit DU of the invention, there are provided in Fig. 8a preferably a first and second over voltage protection circuit PRT1, PRT2 respectively provided at the output of said first and second time delay circuit TD1, TD2 for respectively protecting said first and second switching element Q1, Q2 from over voltages. Preferably, these over voltage protection circuits PRT1, PRT2 can be formed by a number of Zener diodes D3, D4; D5, D6 interconnected as shown in Fig. 8b. These Zener diodes shown in the circuit have no particular function in the time delaying/shifting process and they are used just for protection purposes and can be discarded from the circuit. Also other circuit elements can be used instead of them.

Hereinafter, the functional behaviour of the drive unit DU of Fig. 8a, 8b and of a half-bridge converter HBC employing such a drive unit DU is explained, in particular with respect to the time delay function of the time delay circuits TD1, TD2.

As can be seen from Fig. 8a and Fig. 8b, in the present invention a highly efficient and low cost self time shifting half bridge drive methodology is applied to a general half bridge flyback converter topology. As discussed above, half bridge converter structures including two switching elements are very popular especially for medium power levels less than 1kW when compared with full bridge structures with four switching elements because of their simple structure and low cost.

Also in Fig. 8a and Fig. 8b, as stated earlier, a half bridge structure (the switching stage SS) consists of two serially connected switching element Q1, Q2 to be switched alternately by the time-delayed switching signals S1', S2'. In driving the half-bridge, the inventors noticed two main problems, namely that
1. the upper switching element Q1 is at a different ground level than the lower switching element Q2 (which is connected to ground), and
2. the two complementary switching signals S1, S2 should have a dead time with respect to each other to prevent the switching elements from being open simultaneously, or differently expressed the time delay circuits TD1, TD2 should preferably introduce a respective time delay Δt1; Δt2 such that one switching element e.g. Q1 is switched off completely before the other one switching element e.g. Q2 switches on.

As explained above, the known solutions to these problems are half bridge controller ICs with two time shifted drive signals and pulse transformers for high side driving, totem-pole drive circuits for low voltage applications, or Half bridge high side drive ICs performing both time delay and high side drive in one IC. However, all these solutions increase the cost and size considerably. The half bridge drive concept of the present invention overcomes all above mentioned drawbacks in a very simple, cheap and compact manner. In addition, the possibility that it can be used to drive any half bridge topology is another advantage.

To understand how the inventive drive unit DU in particular addressed the problem 2., the problem 2. is further explained with reference to Fig. 1b-1f. Fig. 1b shows a principle block diagram of the typical Half Bridge switching structure shown in Fig. 1a where the two switching elements Q1, Q2 connected in series are connected in parallel to the input source Vdc. As clearly can be seen from the structure, the switching elements Q1, Q2 should never be on simultaneously to prevent the source from being short circuited. Therefore, before opening a switch, the other one must completely be closed, that is a switching time delay should be introduced both when "turning Q1 on-turning Q2 off" and "turning Q1 off -turning Q2 on". This is the reason for providing - in accordance with the invention - two time delay circuits TD1, TD2.

Fig. 1c shows the switching element Q1, Q2 formed by MOSFET transistor and Fig. 1d shows the equivalent circuit of Fig. 1c in case of switching, for further illustrating the time delay features of the present invention. In Fig. 1d R_{g} is the internal resistor at the gate terminal, and C_{gs} and C_{ds} are gate source and gate drain capacitances respectively. In general, a MOSFET is a voltage controlled switch, in contrary to bipolar transistors and IGBTs which are current controlled switches, and the switching state (on-off) of a MOSFET is determined by the C_{gs} voltage (or gate source voltage).

Fig. 1e shows typical turn-on and turn-off transients of such a MOSFET. In turning-on, if a voltage stress V_{DS} exists across drain-source terminals of such a MOSFET, the MOSFET starts to conduct a current I_{DS} when the gate-source voltage V_{GS} reaches a certain threshold value Vₜₕ and it is completely opened at the end of the so-called "Miller Plateau gate charging process" where V_{GS} stays constant at gate plateau voltage V_{GP} for a certain time t₃. Then total MOSFET turn-on time is t₂ + t₃.

The turning-off process of a MOSFET follows a similar but opposite process as shown in Fig. 1f. The total turn-off time can be described as t₄ + t₅ + t₆. These time durations depend on the parameters of the MOSFET used (listed in the data sheets or technical documents) and applied gate-source pulse voltage. Whilst a direct calculation of these turn-on and turn-off time values is extremely complicated they can be estimated roughly by a simple RC circuit analysis, and can be set experimentally afterwards.

Having understood this basic principle of switching of MOSFETs from Fig. 1d-1f, the time delay Δt1, Δt2 provided by the time delay circuits TD1, TD2 is further explained with reference to the special embodiment of a time delay circuit shown in Fig. 8b and comprising a respective diode D1, D2, a resistor R1, R2 and a bipolar transistor T1, T2 and a capacitor C1, C2 interconnected as shown in Fig. 8b (and also shown in Fig. 9 and Fig. 10). Each time delay circuit TD1, TD2 is respectively connected serially at the output terminal t8, t7 of the respective secondary winding T2-21, T2-22 of the isolation transformer T2.

In the embodiment of the half-bridge driver circuit DU in Fig. 8b the diodes D₁ and D₂ provide a discharge path for the gate-source charge of the corresponding switching MOSFET to be turned-off immediately after the application of a negative pulse voltage, while the part of the time delay circuit TD1, TD2 consisting of the transistor T1, T2, the resistor R1, R2 and the capacitor C1, C2 creates a turn-on time delay for the complementary MOSFET to be turned-on when the complementary positive turn on pulse voltage is applied simultaneously with the turn-off pulse voltage. Furthermore, the turn-on charge path is not available until the base emitter capacitance voltage of the transistor reaches up to a typical threshold value of about 0.65 V. Therefore, this time duration should preferably be at least equal to or greater than the turn-of time (t₄ + t₅ + t₆) of the complementary turning-of MOSFET minus the turn-on start time t₁ of the turning-on MOSFET, i.e (t₄ + t₅ + t₆ - t₁). Here the critical point is that the collector-emitter capacitor C1, C2 should preferably be kept very small compared to the gate-source capacitor C_{gs} of the used MOSFETs such that when the collector-emitter voltage reaches the threshold of about 0.65 V, the MOSFET gate-source voltage is held at a very small value close to zero to guarantee continuity of the off-state of the MOSFET Q1 while the other MOSFET Q2 is being turned-off. The inventive time delay circuits TD1, TD2 advantageously and preferably provide such a time delay as mentioned and discussed above.

It should be noted that the above time delay circuits TD1, TD2 shown in Fig. 8b only show one embodiment of a time delay circuit allowing the introduction of the required time delay Δt1, Δt2. However, other time delay circuits introducing a respective time delay Δt1, Δt2 such that one switching element is switched off completely before the other switching element switches on may be used. Preferably, each time delay circuit is respectively connected serially at the respective output terminal t8, t7 of the respective secondary winding T2-21, T2-22.

### EMBODIMENTS OF THE PRESENT INVENITON

Fig. 9 and Fig 10 show embodiments of the drive unit DU of Fig. 8a, 8b respectively employed for driving a half bridge converter HBC such as the one shown and discussed above in connection with Fig. 1a.

As discussed above in connection with Fig. 1a and Fig. 2, also the half bridge converter HBC in Fig. 9 and Fig. 10 is for converting a DC input voltage Vdc to a DC output voltage Vout and it comprises a switching stage Q1, Q2, SS comprising two serially connected switching elements Q1, Q2, preferably MOSFET transistors, an output transformer T1 having a primary winding T11 connected to said switching stage Q1, Q2, SS and a secondary winding T12 and a half bridge rectifier D*, Co connected to said output transformer T1, said half bridge rectifier D*, Co outputting said DC output voltage Vout. The drive unit DU as shown in Fig. 8a, 8b is inserted in such a way that said first and second time delayed switching pulse signals S1', S2' are fed to a respective control terminal Q1b, Q2b of said first and second switching element Q1, Q2 of said switching stage Q1, Q2, SS of said half bridge converter HBC.

In Fig. 9, a preferred embodiment of the half-bridge converter HBC is shown with the primary winding T11 connected in parallel over the second switching element Q2, i.e. the terminals t1, t4 of said primary winding T11 of said output transformer T1 are respectively connected to a drain Q2d and a source Q2s of the second switching element Q2 of said serially connected MOSFET transistors Q1, Q2 of said switching stage Q1, Q2, SS.

In Fig. 10 a preferred embodiment of the half-bridge converter HBC is shown with the primary winding T11 connected in parallel over the first switching element Q1, i.e. one terminal t1 of said primary winding T11 of said output transformer T1 is connected to the drain Q1d of one MOSFET Q1 of said serially connected MOSFETs Q1, Q2, and the second terminal t4 of said primary winding T11 of said output transformer T1 is connected to the source Q1s of said one MOSFET Q1.

The half bridge flyback converters HBC in Fig. 9 and Fig. 10 block both include a primary driver unit formed by a controller CNTRL outputting the primary control pulse signal CS to the primary winding T21 of said isolation transformer T2. Such a controller may advantageously be formed by a conventional single output voltage mode PWM controller which outputs a pulse-width modulated (PWM) control signal CS. If said control pulse signal CS is a pulse width modulated (PWM) control pulse signal CS, said first and second switching pulse signals S1, S2 and said time delayed first and second switching pulse signals S1', S2' are also PWM switching signals. Advantageously, a second output FB of said PWM controller CNTRL is connected to the output terminal of the half wave rectifier HBR where the converted voltage Vout occurs.

As shown in Fig. 9 and Fig. 10, in the preferred embodiment of the inventive half-bridge converter HBC, here as an example a half-bridge flyback converter HBC, a first input terminal t11 of said primary winding T21 is connected to ground and the serially connected switching elements Q1 and Q2 are also connected to ground at the source Q2s of the lower switching element Q2. Furthermore, it is advantageous to place a coupling capacitor C3 between the PWM controller CNTRL and the primary winding terminal t2.

In operation of the converter in Fig. 9 and Fig. 10, the PWM controller CNTRL generates the required PWM signal to drive the respective switching element. In Fig.9, CNTRL generates the required PWM signal to drive Q1, but in Fig. 10 it generates the required signal to drive Q2. for the power block to perform flyback operation. The pulse transformer (transformer) T2 with its two secondary windings T2-21; T2-22 isolates the ground level of the high side switching element Q1 and also transfers the in-phase drive signal for the high side switch and instantly generates the complementary drive signal for the bottom switch switching element Q2.

As explained in great detail above with reference to the inventive drive unit DU in Fig. 8a, 8b and Fig. 1b-1f, the drive unit DU incorporated in the converter HBC in Fig. 9 and Fig. 10 prevents opening of the relevant switch before the close of the other by means of said time delay circuits TD1, TD2) at the output of each secondary winding T2-21, T2-22 of the pulse transformer T2, i.e. of the conversion stage CST.

As in Fig. 8b, also in Fig. 9 and Fig. 10, each time delay circuit TD1, TD2 is preferably composed of a switching NPN transistor T1, T2, a collector base resistor R1, R2 and a base emitter capacitor C1, C2 which together form the main time shift function, i.e. until the base emitter capacitor charges up to the base emitter threshold voltage the transistor switching element remains closed and does not activate the on-process of the relevant switching element of the respective power block.

In accordance with a particularly advantageous embodiment of the time delay circuits, the provision of diodes D1, D2 placed between emitter and collector of the transistors guarantee the start of the switch off-process immediately after the turn-off signal and protect the transistor from high reverse emitter collector voltages.

### BEST MODE OF THE INVENTION

In a particularly enabling and advantageous best mode of the invention as shown in Fig. 9, a Half bridge Flyback converter stage with its drive unit includes, in a first aspect, two series switching MOSFETS Q1, Q2 in Half bridge structure, a resonating capacitor Cr in series to the primary side T11 of the output transformer T1 such that said primary winding T11 is essentially parallel to the second switching MOSFET Q2, a rectifying diode D* in series to the secondary side T12 of the output transformer T1 and an output bulk capacitor (Co), as the driver unit a single output voltage mode PWM controller CNTRL in series with a DC blocking capacitor C3 and a pulse transformer T2 of two complementary outputs t5-t8 and t6-t7, as one time shifting unit TD1 an NPN transistor T1, a collector base resistor R1, a base emitter capacitor C1 and an emitter collector diode D1 in series with the first output of the pulse transformer t5-t8, a Zener diode D3 and another series but reversely connected Zener diode D4 connected between gate and source of said first switching element Q1, and as another second time shifting unit TD2 an NPN transistor T2, a collector base resistor R2 ,a base emitter capacitor C2 and an emitter collector diode D2 in series to the second output winding T2-22; t6-t7 of the pulse transformer T2, a Zener diode D5 and other series but reversely connected Zener diode D6 connected between gate and source of said second switching element Q2.

In the particularly enabling and advantageous best mode of the invention as shown in Fig. 10, a Half bridge Flyback converter stage with its drive unit includes, in a second aspect, two series switching MOSFETS Q1, Q2 in Half bridge structure, a resonating capacitor Cr in series to the primary side T11 of the output transformer T1 such that said primary winding T11 is essentially parallel to the first switching MOSFET Q1, a rectifying diode D* in series to the secondary side T12 of the output transformer T1 and an output bulk capacitor Co as the driver unit a single output voltage mode PWM controller CNTRL in series with a DC blocking capacitorC3 and a pulse transformer T2 of two complementary outputs t5-t8 and t6-t7, as one time shifting unit TD1 an NPN transistor

T1, a collector base resistor R1, a base emitter capacitor C1 and an emitter collector diode D1 in series with the first output of the pulse transformer t5-t8, a Zener diode D3 and another series but reversely connected Zener diode D4 connected between gate and source of said second switching element Q1, and as another second time shifting unit TD2 an NPN transistor T2, a collector base resistor R2 ,a base emitter capacitor C2 and an emitter collector diode D2 in series to the second output winding T2-22; t6-t7 of the pulse transformer T2, a Zener diode D5 and other series but reversely connected Zener diode D6 connected between gate and source of said second switching element Q2.

Reference numerals in the claims only serve clarification purposes and do not limit the scope of these claims.

## Claims

1. A drive unit (DU) for a half bridge converter (HBC), comprising:
a) a transformer (T2) having a primary winding (T2-1) and two secondary windings (T2-21; T2-22), said primary winding (T2-1) receiving a control pulse signal (CS) from a controller (CNTRL) and said two secondary windings (T2-21, T2-22) outputting a first and second switching pulse signal (S1, S2), said first and second switching pulse signals (S1, S2) being complementary to each other; and
b) a first and a second time delay circuit (TD1, TD2) respectively receiving said first and second complementary switching signal (S1, S2) and introducing a respective time delay (Δt1; Δt2) in said first and second switching signal (S1, S2), said first and second time delayed switching pulse signals (S1'; S2') being fed to a first and second switching element (Q1, Q2) of said half bridge converter (HBC),
***characterized in that***
each time delay circuit (TD1, TD2) respectively comprises a transistor (T1, T2), the source and emitter of which are respectively connected serially at the output terminal (t8, t7) of the respective one of the secondary windings (T2-21, T2-22), and its corresponding switching element (Q1, Q2); a resistor (R1, R2) and a capacitor (C1, C2), serially connected to the resistor, which are parallely connected to the source and emitter of the transistor (T1, T2), the gate of which is connected to the connection between the resistor (R1, R2) and capacitor (C1, C2), and a diode (D1; D2) parallely connected to the source and emitter of the transistor (T1, T2), for providing a discharge path for the corresponding switching element (Q1, Q2).

2. A drive unit (DU) according to claim 1,
***characterized in that***
said time delay circuits (TD1, TD2) introduce a respective time delay (Δt1; Δt2) such that one switching element (Q1) is switched off completely before the other one switching element (Q2) switches on.

3. A drive unit (DU) according to claim 1,
***characterized in that***
a first input terminal (t11) of said primary winding (T2-1) is connected to ground.

4. A drive unit (DU) according to claim 3,
***characterized in that***
a coupling capacitor (C3) is connected to a second input terminal (t2) of said primary winding (T2-1).

5. A drive unit (DU) according to claim 1,
***characterized by***
a first and second over voltage protection circuit (PRT1, PRT2, D3, D4; D5, D6) respectively provided at the output of said first and second time delay circuit (TD1, TD2) for respectively protecting said first and second switching element (Q1, Q2) from over voltages.

6. A drive unit (DU) according to claim 5,
***characterized in that***
each over voltage protection circuit (PRT1, PRT2) comprises a number of Zener diodes (D3, D4; D5, D6).

7. A drive unit (DU) according to claim 1,
***characterized in that***
said control pulse signal (CS) is a pulse width modulated (PWM) control pulse signal (CS), said first and second switching pulse signals (S1, S2) and said time delayed first and second switching pulse signals (S1', S2') are PWM switching signals (S1, S2; S1', S2') and said controller (CNTRL) is a PWM controller (CTRL).

8. A drive unit (DU) according to claim 4,
***characterized in that***
said PWM controller (CNTRL) is a single output voltage mode PWM controller (CNTRL).

9. A half bridge converter (HBC) for converting a DC input voltage (Vdc) to a DC output voltage (Vout), comprising a drive unit (DU) according to one or more of claims 1 to 8,
a) a switching stage (Q1, Q2, SS) comprising two serially connected switching elements (Q1, Q2);
b) an output transformer (T1) having a primary winding (T11) connected to said switching stage (Q1, Q2, SS) and a secondary winding (T12);
c) a half bridge rectifier (D*, Co) connected to said output transformer (T1), said half bridge rectifier (D*, Co) outputting said DC output voltage (Vout); and
d) said first and second time delayed switching pulse signals (S1'; S2') are fed to a respective control terminal (Q1b; Q2b) of said first and second switching element (Q1, Q2) of said switching stage (Q1, Q2, SS) of said half bridge converter (HBC).

10. A half bridge converter (HBC) according to claim 9
***characterized in that***
said switching elements (Q1, Q2) are constituted by MOSFET transistors.

11. A half bridge converter (HBC) according to claim 9,
***characterized in that***
said output transformer (T1) is connected to said switching stage (Q1, Q2, SS) through a resonant coupling capacitor (Cr).

12. A half bridge converter (HBC) according to claim 10,
***characterized in that***
the terminals (t1, t4) of said primary winding (T11) of said output transformer (T1) are respectively connected to a drain (Q2d) and a source (Q2s) of one (Q2) of said serially connected MOSFETs (Q1, Q2) of said switching stage (Q1, Q2, SS).

13. A half bridge converter (HBC) according to claim 11,
***characterized in that***
one terminal (t1) of said primary winding (T11) of said output transformer (T1) is connected to the source (Q1s) of one MOSFET (Q1) of said serially connected MOSFETs (Q1, Q2); and
the second terminal (t4) of said primary winding (T11) of said output transformer (T1) is connected to the drain (Q1s) of said one MOSFET (Q1).

14. A half bridge converter (HBC) according to claim 9,
***characterized in that***
said half bridge converter (HBC) is a half bridge flyback converter.

## Patentansprüche

1. Antriebseinheit (DU) für Halbbrückenwandler (HBC), umfassend:
a) einen Transformator (T2) mit einer Primärwicklung (T2-1) und zwei Sekundärwicklungen (T2-21; T2-22), wobei die Primärwicklung (T2-1) ein Steuerimpulssignal (CS) aus einer Steuerung (CNTRL) empfängt und die zwei Sekundärwicklungen (T2-21, T2-22) ein erstes und ein zweites Umschaltimpulssignal (S1, S2) ausgeben, wobei die ersten und zweiten Umschaltimpulssignale (S1, S2) zueinander komplementär sind; und
b) eine erste und zweite Zeitverzögerungsschaltung (TD1, TD2) die jeweils das erste und zweite komplementäre Umschaltsignal (S1, S2) empfangen und eine entsprechende Zeitverzögerung (Δt1; Δt2) in das erste und zweite Umschaltsignal (S1, S2) einführen, wobei die ersten und zweiten zeitverzögerten Umschaltimpulssignale (S1', S2') einem ersten und zweiten Umschaltelemente (Q1, Q2) des Halbbrückenwandlers (HBC) zugeführt werden,
**dadurch gekennzeichnet, dass**
jede Zeitverzögerungsschaltung (TD1, TD2) jeweils umfasst: einen Transistor (T1, T2), dessen Quelle und Emitter am Ausgangsanschluss (t8, t7) der jeweiligen Sekundärwicklung (T2-21, T2-22) und seinem entsprechenden Umschaltelement (Q1, Q2) verbunden sind; einen Widerstand (R1, R2) und einen Kondensator (C1, C2), der seriell mit dem Widerstand verbunden ist, die parallel mit Quelle und Emitter des Transistors (T1, T2) verbunden sind, dessen Gatter mit der Verbindung zwischen dem Widerstand (R1, R2) und dem Kondensator (C1, C2) verbunden ist, und eine Diode (D1; D2), die parallel mit der Quelle und dem Emitter des Trägersignal (T1, T2) verbunden ist, um einen Entladungspfad für das entsprechende Umschaltelement (Q1, Q2) bereitzustellen.

2. Antriebseinheit (DU) gemäß Anspruch 1, **dadurch gekennzeichnet, dass**
die Zeitverzögerungsschaltungen (TD1, TD2) eine entsprechende Zeitverzögerung (Δt1; Δt2) so einführen, dass ein Umschaltelement (Q1) komplett abgeschaltet wird, bevor das andere Umschaltelement (Q2) einschaltet.

3. Antriebseinheit (DU) gemäß Anspruch 1, **dadurch gekennzeichnet, dass**
ein erster Eingangsanschluss (t11) der Primärwicklung (T2-1) mit Erde verbunden ist.

4. Antriebseinheit (DU) gemäß Anspruch 3, **dadurch gekennzeichnet, dass**
ein Kopplungskondensator (C3) mit einem zweiten Eingangsanschluss (t2) der Primärwicklung (T2-1) verbunden ist.

5. Antriebseinheit (DU) gemäß Anspruch 1, **gekennzeichnet durch**
eine erste und zweite Überspannungsschutzschaltung (PRT1, PRT2, D3, D4; D5, D6), die jeweils am Ausgang der ersten und zweiten Zeitverzögerungsschaltung (TD1, TD2) vorgesehen sind, um jeweils die ersten und zweiten Umschaltelemente (Q1, Q2) gegenüber Überspannungen zu schützen.

6. Antriebseinheit (DU) gemäß Anspruch 5, **dadurch gekennzeichnet, dass**
jede Überspannungsschutzschaltung (PRT1, PRT2) eine Anzahl von Zenerdioden (D3, D4; D5, D6) umfasst.

7. Antriebseinheit (DU) gemäß Anspruch 1, **dadurch gekennzeichnet, dass**
das Steuerimpulssignal (CS) ein Pulsweiten-moduliertes (PWM) Steuerimpulssignal (CS) ist, die ersten und zweiten Umschaltimpulssignale (S1, S2) und zeitverzögerten ersten und zweiten Umschaltimpulssignale (S1', S2') PWM-Umschaltsignale (S1, S2; S1', S2') sind und die Steuerung (CNTRL) eine PWM-Steuerung (CTRL) ist.

8. Antriebseinheit (DU) gemäß Anspruch 4, **dadurch gekennzeichnet, dass**
die PWM-Steuerung (CNTRL) eine Einzelausgangsspannungsmodus-PWM-Steuerung (CNTRL) ist.

9. Halbbrückenwandler (HBC) zum Umwandeln einer Gleichstromeingangsspannung (Vdc) in eine GleichstromAusgangsspannung (Vout), umfassend eine Antriebseinheit (DU) gemäß einem oder mehrerer der Ansprüche 1 bis 8,
a) eine Umschaltstufe (Q1, Q2, SS), die zwei seriell verbundene Umschaltelemente (Q1, Q2) umfasst;
b) einen Ausgangstransformator (T1) mit einer Primärwicklung (T11), die mit der Umschaltstufe (Q1, Q2, SS) und einer Sekundärwicklung (T12) verbunden ist;
c) ein Halbbrückengleichrichter (D*, Co), der mit dem Ausgangstransformator (T1) verbunden ist, wobei der Halbbrückengleichrichter (D*, Co) die Gleichstromausgangsspannung (Vout) ausgibt; und
d) die ersten und zweiten zeitverzögerten Umschaltimpulssignale (S1', S2') einem entsprechenden Steueranschluss (Q1b; Q2b des ersten und zweiten Umschaltelementes der Umschaltstufe (A1, Q2, SS) des Halbbrückenwandlers (HBC) zugeführt werden.

10. Halbbrückenwandler (HBC) gemäß Anspruch 9, **dadurch gekennzeichnet, dass**
die Umschaltelemente (Q1, Q2) aus MOSFET-Transistoren aufgebaut sind.

11. Halbbrückenwandler (HBC) gemäß Anspruch 9, **dadurch gekennzeichnet, dass**
der Ausgangstransformator (T1) mit der Umschaltstufe (Q1, Q2, SS) über einen resonanten Kopplungskondensator (Cr) verbunden ist.

12. Halbbrückenwandler (HBC) gemäß Anspruch 10, **dadurch gekennzeichnet, dass**
die Anschlüsse (t1, t4) der Primärwicklung (T11) des Ausgangstransformators (T1) jeweils mit einem Abfluss (Q2d) und einer Quelle (Q2s) eines (Q2) der seriell verbundenen MOSFETs (Q1, Q2) der Umschaltstufe (Q1, Q2, SS) verbunden sind.

13. Halbbrückenwandler (HBC) gemäß Anspruch 11, **dadurch gekennzeichnet, dass**
ein Anschluss (t1) der Primärwicklung (T11) des Ausgangstransformators (T1) mit der Quelle (Q1s) eines MOSFETs (Q1) der seriell verbundenen MOSFETs (Q1, Q2) verbunden ist; und
der zweite Anschluss (t4) der Primärwicklung (T11) des Ausgangstransformators (T1) mit dem Abfluss (Q1s) des einen MOSFET (Q1) verbunden ist.

14. Halbbrückenwandler (HBC) gemäß Anspruch 9, **dadurch gekennzeichnet, dass**
der Halbbrückenwandler (HBC) ein Halbbrückensperrwandler ist.

## Revendications

1. Unité de commande (DU) pour un convertisseur en demi pont (HBC) comprenant :
a) un transformateur (T2) qui possède un enroulement primaire (T2-1) et deux enroulements secondaires (T2-21; T2-22), ledit enroulement primaire (T2-1) recevant un signal d'impulsion de commande (CS) provenant d'une unité de commande (CNTRL) et lesdits deux enroulements secondaires (T2-21; T2-22) délivrant en sortie un premier et un deuxième signaux d'impulsions de commutation (S1, S2), lesdits premier et deuxième signaux d'impulsions de commutation (S1, S2) étant complémentaires entre eux ; et b) un premier et un deuxième circuits de retard temporel (TD1, TD2) recevant respectivement lesdits premier et deuxième signaux de commutation (S1, S2) complémentaires et introduisant un retard temporel (Δt1; Δt2) dans lesdits premier et deuxième signaux de commutation (S1, S2), lesdits premier et deuxième signaux d'impulsions de commutation (S1' ; S2') retardés dans le temps étant alimentés à un premier et à un deuxième éléments de commutation (Q1, Q2) dudit convertisseur en demi pont (HBC),
**caractérisée en ce que**
chaque circuit de retard temporel (TD1, TD2) comprend respectivement un transistor (T1, T2), dont la source et l'émetteur sont respectivement connectés en série au niveau de la borne de sortie (t8, t7) de l'enroulement respectif des enroulements secondaires (T2-21, T2-22), et de son élément de commutation (Q1, Q2) correspondant ; une résistance (R1, R2) et un condensateur (C1, C2), connecté en série à la résistance, qui sont connectés en parallèle à la source et à l'émetteur du transistor (T1, T2), dont la grille est connectée à la connexion entre la résistance (R1, R2) et le condensateur (C1, C2), et une diode (D1; D2) connectée en parallèle à la source et à l'émetteur du transistor (T1, T2), pour fournir une voie de décharge pour l'élément de commutation (Q1, Q2) correspondant.

2. Unité de commande (DU) selon la revendication 1,
**caractérisée en ce que**
lesdits circuits de retard temporel (TD1, TD2) introduisent un retard temporel (Δt1; Δt2) respectif tel qu'un élément de commutation (Q1) est complètement éteint avant que l'autre élément de commutation (Q2) ne s'allume.

3. Unité de commande (DU) selon la revendication 1,
**caractérisée en ce que**
une première borne d'entrée (t11) dudit enroulement primaire (T2-1) est connectée à la terre.

4. Unité de commande (DU) selon la revendication 3,
**caractérisée en ce que**
un condensateur de couplage (C3) est connecté à une deuxième borne d'entrée (t2) dudit enroulement primaire (t2-1).

5. Unité de commande (DU) selon la revendication 1,
**caractérisée par**
un premier et un deuxième circuits (PRT1, PRT2, D3, D4 ; D5, D6) de protection contre les surtensions prévus respectivement au niveau de la sortie desdits premier et deuxième circuits de retard temporel (TD1, TD2) destinés respectivement à protéger lesdits premier et deuxième éléments de commutation (Q1, Q2) contre des surtensions.

6. Unité de commande (DU) selon la revendication 5,
**caractérisée en ce que**
chaque circuit (PRT1, PRT2) de protection contre les surtensions comprend un nombre de diodes Zener (D3, D4 ; D5, D6).

7. Unité de commande (DU) selon la revendication 1,
**caractérisée en ce que**
ledit signal d'impulsion de commande (CS) est un signal de commande (CS) à modulation de largeur d'impulsions (PWM), lesdits premier et deuxième signaux d'impulsions de commutation (S1, S2) et lesdits premier et deuxième signaux d'impulsions de commutation (S1', S2') retardés dans le temps sont des signaux de commutation PWM (S1, S2 ; S1', S2') et ladite unité de commande (CNTRL) est une unité de commande PWM (CNTRL).

8. Unité de commande (DU) selon la revendication 4,
**caractérisée en ce que**
ladite unité de commande PWM (CNTRL) est une unité de commande PWM (CNTRL) en mode tension de sortie simple.

9. Convertisseur en demi pont (HBC) destiné à convertir une tension d'entrée (Vdc) courant continu en une tension de sortie (Vout) courant continu, comprenant une unité de commande (DU) selon l'une des revendications 1 à 8,
a) un étage de commutation (Q1, Q2, SS) comprenant deux éléments de commutation (Q1; Q2) connectés en série ;
b) un transformateur de sortie (T1) ayant un enroulement primaire (T11) connecté audit étage de commutation (Q1, Q2, SS) et un enroulement secondaire (T12) ;
c) un redresseur (D*, Co) en demi pont connecté audit transformateur de sortie (T1), ledit redresseur (D*, Co) en demi pont délivrant en sortie ladite tension de sortie (Vout) courant continu ; et
d) lesdits premier et deuxième signaux d'impulsions de commutation (S1' ; S2') retardés dans le temps sont alimentés à une borne de commande (Qlb ; Q2b) respective desdits premier et deuxième éléments de commutation (Q1, Q2) dudit étage de commutation (Q1, Q2, SS) dudit convertisseur en demi pont (HBC).

10. Convertisseur en demi pont (HBC) selon la revendication 9
**caractérisé en ce que**
lesdits éléments de commutation (Q1, Q2) sont constitués par des transistors MOSFET.

11. Convertisseur en demi pont (HBC) selon la revendication 9
**caractérisé en ce que**
ledit transformateur de sortie (T1) est connecté audit étage de commutation (Q1, Q2, SS) à travers un condensateur de couplage résonant (Cr).

12. Convertisseur en demi pont (HBC) selon la revendication 10
**caractérisé en ce que**
les bornes (t1, t4) dudit enroulement primaire (T11) dudit transformateur de sortie (T1) sont connectées respectivement à un drain (Q2d) et à une source (Q2s) de l'un (Q2) desdits transistors MOSFET (Q1, Q2) connectés en série dudit étage de commutation (Q1, Q2, SS).

13. Convertisseur en demi pont (HBC) selon la revendication 11
**caractérisé en ce que**
une borne (t1) dudit enroulement primaire (T11) dudit transformateur de sortie (T1) est connectée à la source (Q1s) d'un MOSFET (Q1) desdits MOSFET (Q1, Q2) connectés en série ; et
la deuxième borne (t4) dudit enroulement primaire (T11) dudit transformateur de sortie (T1) est connectée au drain (Q1s) dudit MOSFET (Q1).

14. Convertisseur en demi pont (HBC) selon la revendication 9
**caractérisé en ce que**
ledit convertisseur en demi pont (HBC) est un convertisseur en demi pont de type flyback.
